Europäisches Patentamt

European Patent Office

Office européen des brevets

(19)

(11) Veröffentlichungsnummer : **0 065 667**
**B1**

(12) **EUROPÄISCHE PATENTSCHRIFT**

(45) Veröffentlichungstag der Patentschrift :
30.12.86

(51) Int. Cl.⁴ : **H 03 K 17/693**, H 03 M 7/04

(21) Anmeldenummer : **82103731.4**

(22) Anmeldetag : **01.05.82**

(54) **CMOS-Auswahlschaltung.**

(30) Priorität : 21.05.81 DE 3120163

(43) Veröffentlichungstag der Anmeldung :
01.12.82 Patentblatt 82/48

(45) Bekanntmachung des Hinweises auf die Patenterteilung : 30.12.86 Patentblatt 86/52

(84) Benannte Vertragsstaaten :
DE FR GB IT NL

(56) Entgegenhaltungen :
US-A- 3 970 865
US-A- 4 190 897
US-A- 4 324 991
ELECTRONIC ENGINEERING, Band 50, Nr. 612, September 1978, Seiten 23,25,27-29,31, London (GB);
D. BOWERS: "Analogue multiplexers: their technology and operation".

(73) Patentinhaber : Deutsche ITT Industries GmbH
Hans-Bunte-Strasse 19 Postfach 840
D-7800 Freiburg (DE)
DE
ITT INDUSTRIES INC.
320 Park Avenue
New York, NY 10022 (US)
FR GB IT NL

(72) Erfinder : Adam, Fritz Günter Dr. rer. nat, Dipl.-Phys.
Furtwänglerstrasse 10
D-7800 Freiburg (DE)

(74) Vertreter : Morstadt, Volker, Dipl.-Ing.
c/o Deutsche ITT Industries GmbH Patent/Lizenzabteilung Postfach 840 Hans-Bunte-Strasse 19
D-7800 Freiburg/Brsg. (DE)

# 0 065 667

**Beschreibung**

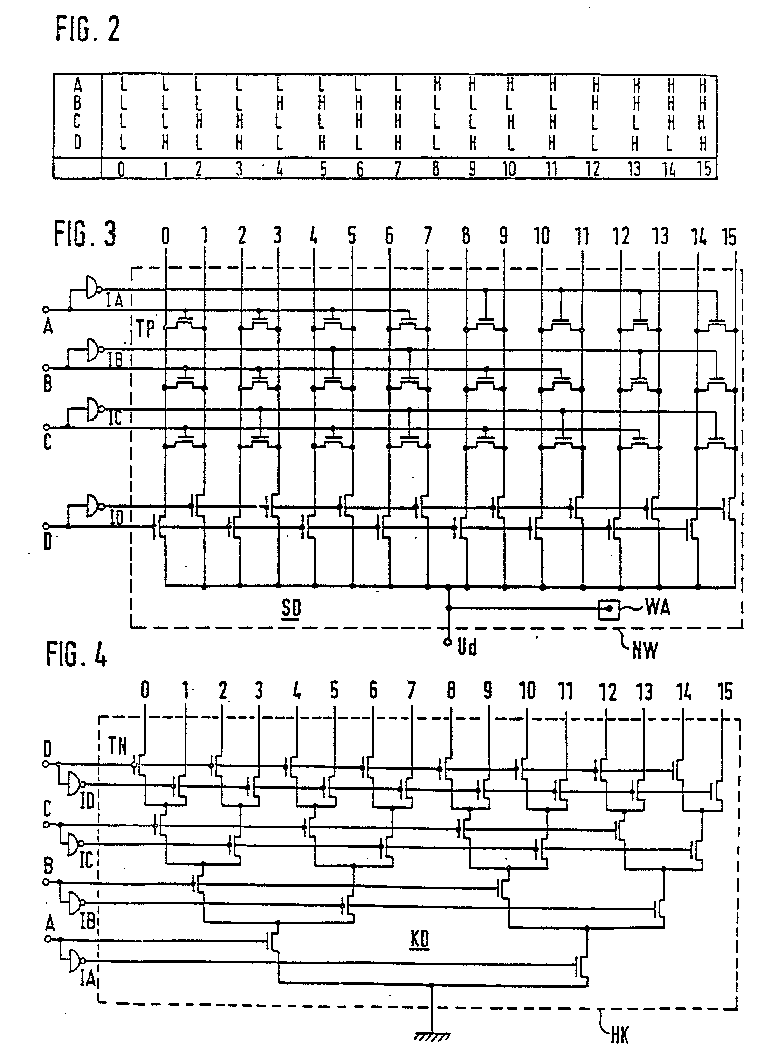

Die Erfindung betrifft eine integrierte Auswahlschaltung für eine Anzahl N von Potentialen U..., die in komplementärer Isolierschicht-Feldeffekttransistor-Technik realisiert ist, entsprechend dem Oberbegriff des Anspruchs 1, wie er aus « Electronic Engineering », September 1978, Bd. 50, Nr. 612, Seiten 23 bis 31, insbesondere Fig. 3 und Fig. 6 mit zugehöriger Beschreibung bekannt ist.

Diese Auswahlschaltung ist zur Ansteuerung mit dreistelligem Binärsignal konzipiert und besteht aus bezüglich des Spannungsausgangs parallelgeschalteten Transmission-Gates, wobei jeweils ein Transmission-Gate jedem der Potentiale eingangsseitig zugeordnet ist und ausgangsseitig alle Transmission-Gates mit dem Spannungsausgang verbunden sind. Die Anzahl der Transmission-Gates entspricht dabei der Anzahl N der Potentiale und ist auch gleich der Anzahl der Zustände des Binärsignals. So zeigt die erwähnte Fig. 3 eine Anordnung für ein dreistelliges Binärsignal mit demzufolge $2^3 = 8$ als Schaltersymbole gezeichneten Transmission-Gates, die von einem CMOS-Eins-Aus-N-Dekoder gesperrt oder leitend gesteuert werden, entsprechend Fig. 6.

Es ist Aufgabe der in den Ansprüchen gekennzeichneten Erfindung, die bekannte CMOS-Auswahlschaltung so auszubilden, daß auch bei großem N ein kleiner Ausgangswiderstand bei gleichzeitig kleinster Leistungsaufnahme der Gesamtschaltung gewährleistet ist.

Ferner sind ähnliche Auswahlschaltungen beispielsweise aus der DE-A 26 07 042, Figuren 2 und 3 bekannt. Diese Auswahlschaltungen sind zur Ansteuerung mit zwei- oder dreistelligem Binärsignal konzipiert und bestehen aus bezüglich des Spannungsausgangs parallelgeschalteten Serienschaltungen von N-Kanal- bzw. P-Kanal-Transistoren, wobei die Anzahl der Transistoren gleichen Kanalleitungstyps pro Serienschaltung der Stellenzahl des Binärsignals entspricht und die Anzahl der Serienschaltungen gleich der Anzahl der Zustände des Binärsignals ist. So zeigt die erwähnte Figur 2 eine Anordnung für ein zweistelliges Binärsignal mit demzufolge $2^2 = 4$ Serienschaltungen und pro Serienschaltung zwei N-Kanal- bzw. zwei P-Kanal-Transistoren. Die erwähnte Figur 3 zeigt für ein dreistelliges Binärsignal eine Anordnung mit $2^3 = 8$ Serienschaltungen pro Serienschaltung drei P-Kanal- bzw. drei N-Kanal-Transistoren.

Die Anzahl N der von den bekannten Anordnungen durchschaltbaren Potentiale ist gleich der Anzahl der Zustände des Binärsignals, wobei die halbe Anzahl N/2 der Potentiale, die in der negativen Hälfte des Betriebsspannungsbereichs liegen, mit den Serienschaltungen aus N-Kanal-Transistoren verbunden werden, während die andere (positivere) Hälfte mit den P-Kanal-Serienschaltungen verbunden werden. Mit der Anordnung nach der Figur 2 können daher insgesamt vier Potentiale und mit der nach Figur 3 acht Potentiale durchgeschaltet werden. Die Ansteuerung der Gates der einzelnen Transistoren erfolgt mittels der einzelnen Stellen entweder direkt oder über zwischengeschaltete Inverter, wobei über deren konkrete schaltungstechnische Realisierung jedoch nichts ausgesagt ist.

Die Anordnungen nach diesem Stand der Technik erkaufen jedoch die Vorteile geringer Leistungsaufnahme und geringer Transistorzahl mit dem Nachteil eines höheren Ausgangswiderstandes des jeweils durchgeschalteten Potentials. Dieser höhere Ausgangswiderstand ergibt sich aufgrund der Reihenschaltung von mehr als einem Transistor, falls die Kanalbreite der Transistoren und damit ihr Flächenbedarf nicht proportional zur Transistorzahl pro Serienschaltung vergrößert wird. Mit dieser Maßnahme würde aber (besonders bei großem N) der Vorteil der geringen Transistorzahl wieder verloren gehen.

Die geringe Leistungsaufnahme wird gegenüber der Anordnung nach der DE-A 26 07 042 dadurch erzielt, daß durch die Verwendung eines CMOS-Eins-Aus-N-Decoders gemäß des kennzeichnenden Teils des Patentanspruchs 1 nur ein sehr kleiner Ruhestrom aufgrund von Sperrströmen auftritt. Die Erfindung hat gegenüber den bekannten Anordnungen nach der DE-A 26 07 042 auch den Vorteil, daß die N Potentiale beliebig über den Betriebsspannungsbereich 0 ... Ud verteilt sein können. Es muß also nicht notwendigerweise wie bei der DE-A 26 07 042 die eine Hälfte (N/2) der Potentiale zwischen 0 und Ud/2 und die andere zwischen Ud/2 und Ud liegen, sondern es ist nach dem Erfindungsprinzip z. B. durchaus auch möglich, alle N Potentiale der einen oder der anderen Hälfte des Gesamtpotentialbereichs zuzuordnen.

Die Erfindung wird nun anhand der Figuren der Zeichnung näher erläutert.

Figur 1 zeigt, teilweise schematisch, ein Ausführungsbeispiel der Erfindung für maximal acht auszuwählende Potentiale entsprechend einem dreistelligen Auswahlsignal,

Figur 2 zeigt die Zustandszuordnung für ein vierstelliges, natürlich-binärcodiertes Auswahlsignal,

Figur 3 zeigt das Schaltbild eines Eins-Aus-N-Sperrdecoders für das vierstellige Binärsignal nach Fig. 2,

Figur 4 zeigt das Schaltbild eines Eins-Aus-N-Kurzschlußdecoders für das vierstellige Binärsignal nach Fig. 2 und

Figur 5 zeigt das Schaltbild einer Vereinfachung der Erfindung für maximal vier auszuwählende Potentiale.

In Fig. 1a ist, teilweise schematisch, das Schaltbild einer Ausführungsform der Erfindung für maximal acht auszuwählende Potentiale U1 ... U8 gezeigt, die in Abhängigkeit von den acht Zuständen 1 ... 8 des dreistelligen digitalen Auswahlsignals A, B, C zum Ausgang U durchschaltbar sind. Jedem der acht Potentiale U1 ... U8 ist ein Transmission-Gate G1 ... G8 zugeordnet, dessen Schaltstrecke zwischen dem

2

jeweiligen Potentiale und dem Spannungsausgang U angeordnet ist.

Die jeweiligen Steuereingänge der Transmission-Gates sind entweder direkt (in Fig. 1a sind das die Gates der P-Kanal-Transistoren) oder über die jeweils zugeordneten Inverter I1 ... I8 (in Fig. 1a sind das die N-Kanal-Transistoren) von jeweiligen Ausgang 1 ... 8 des CMOS-Eins-Aus-N-Decoders angesteuert. Im Ausführungsbeispiel der Fig. 1a besteht dieser Decoder aus zwei Teilen, nämlich dem Eins-Aus-N-Sperrdecoder SD und dem Eins-Aus-N-Kurzschlußdecoder KD, deren gleichnamige Ausgänge miteinander verbunden sind und deren gleichnamige Adreßeingänge vom erwähnten Ausgangssignal A, B, C gemeinsam entweder direkt oder über die zugeordneten Vorinverter IA, IB, IC angesteuert sind. Der Sperrdecoder SD besteht aus Transistoren des einen Kanalleitungstyps, die in einer Isolierwanne des anderen Kanalleitungstyps innerhalb des Halbleiterkörpers der integrierten Auswahlschaltung angeordnet sind, die mit der Betriebsspannung Ud verbunden ist. Der Kurzschlußdecoder KD besteht aus Transistoren des anderen Kanalleitungstyps, die innerhalb des Halbleiterkörpers angeordnet sind.

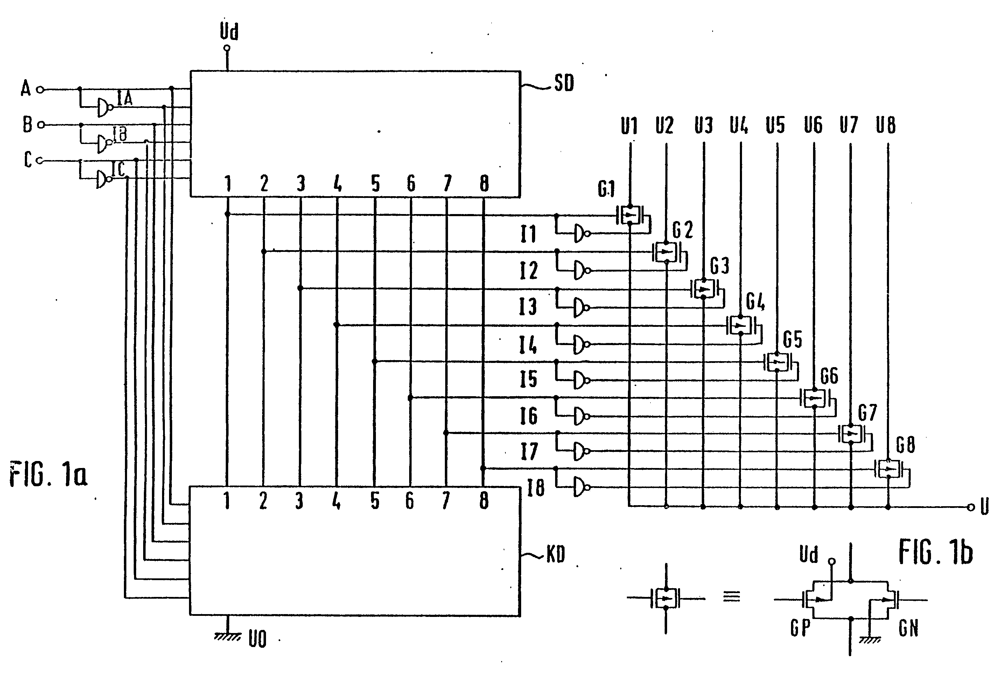

In Fig. 1b ist genauer gezeigt, wie die beiden Teiltransistoren der Transmission-Gates G1 ... G8 bezüglich ihres Substrats zu beschalten sind. So ist das Substrat des P-Kanal-Teiltransistors GP mit der Betriebsspannung Ud und das des N-Kanal-Teiltransistors GN mit dem Schaltungsnullpunkt zu verbinden, an dem auch der Halbleiterkörper HK der Auswahlschaltung liegt.

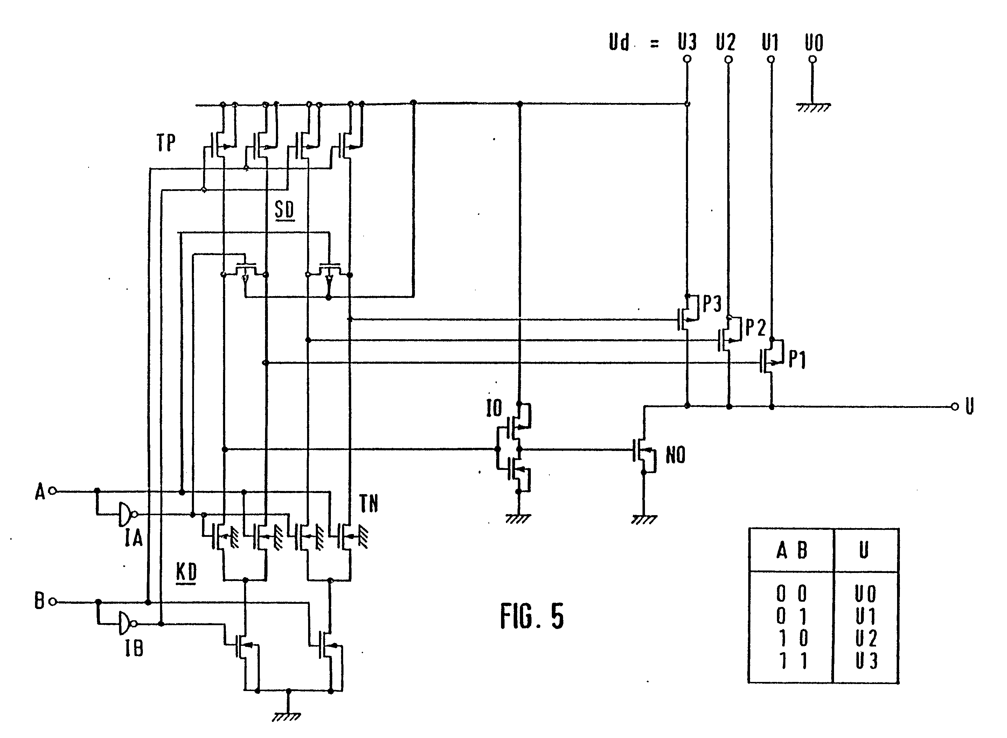

Die Tabelle der Fig. 2 zeigt die Zustände eines vierstelligen, natürlich-binärcodierten Digitalsignals, wie es zur Ansteuerung der in den Figuren 3 und 4 gezeigten Decoder verwendet werden kann.

So zeigt die Fig. 3 das Schaltbild eines mit diesem vierstelligen Auswahlsignal A ... D ansteuerbaren Sperrdecoders SD, der ausschließlich aus P-Kanal-Transistoren TP aufgebaut ist. Das funktionsmäßig Charakteristische dieses Sperrdecoders ist, daß alle nicht-adressierten Decoderausgänge zur Betriebsspannung Ud durchgeschaltet sind, während die Leitungsverbindungen zwischen dem adressierten Ausgang und Ud unterbrochen ist. Alle P-Kanal-Transistoren TP sind in der N-leitenden Isolierwanne NW des Halbleiterkörpers angeordnet, die ihrerseits über den Kontakt WA mit der Betriebspannung Ud verbunden ist.

Der schaltungstechnische Aufbau des Sperrdecoders SD nach Fig. 3 läßt sich so beschreiben, daß der niederstwertigen Stelle D des Auswahlsignals je einer der zu den 16 Ausgängen gehörenden Längstransistoren zugeordnet ist, die zwischen der Betriebsspannung Ud und dem entsprechenden Ausgang liegen. Diese Längstransistoren sind abwechselnd jeweils vom Auswahl-Stellensignal D direkt oder über den Vorinverter ID angesteuert. Die beiden Ausgänge eines derartigen Längstransistoren-Paares sind dann über drei jeweils den restlichen drei Stellen des Binärsignals zugeordnete Quertransistoren miteinander verbunden, die entsprechend der Figur 3 direkt oder über den entsprechenden Vorinverter vom entsprechenden Auswahl-Stellensignal A, B, C angesteuert sind.

Die Figur 4 zeigt das Schaltbild des entsprechenden Kurzschlußdecoders KD, der ausschließlich mit N-Kanal-Transistoren TN realisiert ist, die im Halbleiterkörper HK angeordnet sind, der mit dem Schaltungsnullpunkt verbunden ist. Das funktionsmäßig Charakteristische des Kurzschlußdecoders KD ist, daß alle Verbindungsleitungen zwischen dem Schaltungsnullpunkt und den nicht-adressierten Decoderausgängen mindestens durch einen gesperrten Transistor unterbrochen sind, während die Verbindungsleitung zwischen der adressierten Ausgangsleitung und dem Schaltungsnullpunkt mittels der in Serie liegenden Transistoren durchgeschaltet ist. Der schaltungsmäßige Aufbau kann etwa so beschrieben werden, daß, ausgehend von dem dem höchstwertigen Stellensignal A zugeordneten und sourceseitig mit dem Schaltungsnullpunkt verbundenen Transistorpaar, der Aufbau sich baum-artig zu den Stellensignalen niedriger Wertigkeit hin jeweils in zwei Ästen verzweigt. Dabei sind die beiden Transistoren, die jeweils sourceseitig zusammengeschaltet sind, vom entsprechenden Stellensignal direkt bzw. über den Vorinverter angesteuert.

Durch die ausgangsseitige Parallelschaltung der beiden Decoder nach den Figuren 3 und 4 ergibt sich somit für jede einer Adresse zugeordnete Verbindungsleitung zwischen Schaltungsnullpunkt und Betriebsspannung Ud das einem einfachen CMOS-Inverter entsprechende Verhalten, und zwar derart, daß der jeweils adressierte Ausgang das Potential des Kurzschlußdecodersubstrats (in den Figuren das Potential des Schaltungsnullpunkts) annimmt, während alle nichtadressierten Ausgänge das Potential des Sperrdecodersubstrats (in den Fig. das Potential der Betriebsspannung Ud) annehmen.

Die Fig. 5 zeigt eine Vereinfachung der erfindungsgemäßen Auswahlschaltung, und zwar der Einfachheit halber für vier auszuwählende Potentiale U0 ... U3, wobei das letztere Potential U3 mit der Betriebsspannung Ud identisch ist und das Potential U0 am Schaltungsnullpunkt liegt. Die Vereinfachung besteht darin, daß bei den Transmission-Gates nur die Einzeltransistoren desjenigen Kanalleitungstyps vorhanden sind, der das zugeordnete Potential schneller und niederohmiger zum Spannungsausgang U durchschaltet, und daß nur diejenigen Inverter vorhanden sind, die aufgrund des Kanalleitungstyps des vorhandenen Transistors erforderlich sind. Die Fig. 5 zeigt somit die den Potentialen U1, U2, U3 zugeordneten P-Kanal-Transistoren P1, P2, P3 sowie den dem Potential U0 zugeordneten N-Kanal-Transistor N0, dessen Gate vom CMOS-Inverter I0 angesteuert ist. Die Decoder SD, KD sind Eins-Aus-Vier-Decoder für das zweistellige Auswahlsignal A, B, wobei das Substrat der P-Kanal-Transistoren TP des Sperrdecoders SD an der Betriebsspannung Ud und das Substrat der N-Kanal-Transistoren TN des Kurzschlußdecoders KD am Schaltungsnullpunkt liegen. Dem Potential U0 am Spannungsausgang U ist der Zustand 00 des Auswahlsignals A, B zugeordnet.

Bei diesem Beispiel der Fig. 5 ist angenommen, daß die Potentiale U1, U2 und U3 sämtlich positiv und größer als oder höchstens gleich (Ud + U0)/2 sind.

Bei der Erfindung in ihrer vereinfachten Form, bei der die Transmission-Gates durch Einzeltransistoren ersetzt und die für ihre Ansteuerung eingesetzten Inverter, wo entbehrlich, weggelassen sind, gelten ganz allgemein (und etwas genauer) die folgenden Regeln :

Für die mit Hilfe von Einzeltransistoren des N-Kanaltyps zum Ausgang U durchzuschaltenden Potentiale Uni gilt :

$$U0 \leqslant Uni < U_{Gn} - U_{Tn}(Uni)$$

Hierbei ist $U_{Gn}$ das Steuerpotential am Gate des betreffenden N-Kanaltransistors und kann, da es aus einer CMOS-Schaltung gewonnen wird, praktisch gleich der Betriebsspannung Ud > 0 gesetzt werden. Es gilt also :

$$U0 \leqslant Uni < Ud - U_{Tn}(Uni) \qquad (1)$$

Der Ausdruck $U_{Tn}(Uni)$ soll andeuten, daß die Schwellenspannung derjenigen Transistoren, die direkt in den Halbleiterkörper als Substrat eingelassen sind, gegenüber ihrem Normalwert $U_{Tn0}$ vergrößert ist, und zwar um den aufgrund der Potentialdifferenz (Uni — U0) zwischen Sourceelektrode und Substrat zustandekommenden sogenannten Substrateffekt $\Delta U_T(Uni)$ :

$$U_{Tn}(Uni) = U_{Tn0} + \Delta U_T(Uni)$$

mit

$$\Delta U_T = K(\sqrt{Uni - U0 + |2\,\phi_F|} - \sqrt{|2\,\phi_F|})\,.$$

Hierbei ist $\Phi_F$ die Spannung, die dem energetischen Abstand zwischen der Bandlückenmitte und dem Fermi-Niveau des Substratmaterials entspricht. Es wird also vorausgesetzt, daß die CMOS-Schaltung mit N-Isolierwannen realisiert ist, d. h. daß alle N-Kanal-Transistoren direkt in einen P-leitenden Halbleiterkörper als Substrat eingelassen sind und daß P-Kanaltransistoren in N-leitenden Isolierwannen unterzubringen sind. Die P-Kanal-Transistoren, die Transmission-Gates ersetzen sollen, werden gemäß der Erfindung in individuelle N-Isolierwannen eingesetzt, um hier den Substrateffekt zu vermeiden. Dabei kann weiter vereinfachend der P-Kanal-Transistor P3 in der Isolierwanne NW des Sperrdekoders SD angeordnet sein, weil er wie die P-Kanal-Transistoren TP des Sperrdekoders SD der Betriebsspannung Ud zugeordnet ist. Für die von den P-Kanaltransistoren zu schaltenden Potentiale Upi gilt dann die Bedingung

$$Ud \geqslant Upi > U_{Gp} + |U_{Tpo}|\,.$$

Da wiederum das Steuerpotential $U_{Gp}$ aus einer CMOS-Schaltung gewonnen wird, ist $U_{Gp}$ praktisch gleich dem Potential des Schaltungsnullpunkt U0 und es gilt somit :

$$Ud \geqslant Upi > U0 + |U_{Tpo}|\,. \qquad (2)$$

Ersetzt man U0 = 0, so vereinfachen sich (1) und (2) zu :

$$0 \leqslant Uni < Ud - U_{Tn}(Uni) \qquad (1a)$$

für die N-Kanal-Ausgangstransistoren und

$$Ud \geqslant Upi > |U_{Tpo}| \qquad (2a)$$

für die P-Kanal-Ausgangstransistoren. Die zulässigen Potentialbereiche für die Uni und Upi überlappen sich erfindungsgemäß nach (1a) und (2a), wenn die Betriebsspannung Ud größer ist als die Summe der Schwellenspannungsbeträge.

Wird die CMOS-Technologie mit P-Isolierwannen in einen N-leitenden Halbleiterkörper realisiert anstatt — wie bisher ausgeführt — mit N-Isolierwannen in einem P-leitenden Halbleiterkörper, so treten Substrateffekte gegebenenfalls bei den P-Kanal-Ausgangstransistoren auf, während die N-Kanal-Ausgangstransistoren, die dann in P-Isolier-Wannen sitzen, davon verschont bleiben.


**Patentansprüche**

1. Integrierte Auswahlschaltung für eine Anzahl N von Potentialen (U...), die in komplementärer Isolierschicht-Feldeffekttransistor-Technik (CMOS-Auswahlschaltung) realisiert ist, wobei
— jedem der N Potentiale (U...) ein Transmission-Gate (G...) zugeordnet ist, dessen Schaltstrecke zwischen dem Potential (U...) und dem Ausgang (U) der Auswahlschaltung liegt, und
— die beiden Steuereingänge des jeweiligen Transmission-Gates (G...) direkt bzw. über einen jeweils zugeordneten Inverter (I...) mit dem entsprechenden Ausgang eines CMOS-Eins-Aus-N-Decoders verbunden sind,
gekennzeichnet durch folgende Merkmale :
— der CMOS-Eins-Aus-N-Decoder besteht aus einem Eins-Aus-N-Sperrdecoder (SD) und aus einem Eins-Aus-N-Kurzschlußdecoder (KD), deren Adreßeingänge paarweise miteinander und deren gleichnamige Ausgänge (1 ... 8) miteinander verbunden sind,
— der Sperrdecoder (SD) besteht aus Transistoren (TP) des einen kanalleitungstyps (P-Kanal in den Figuren), die in einer Isolierwanne (NW) des anderen Kanalleitungstyps (N-Kanal in den Figuren) innerhalb des Halbleiterkörpers der integrierten Auswahlschaltung angeordnet sind, und
— der Kurzschlußdecoder (KD) besteht aus Transistoren (TN) des anderen Kanalleitungstyps, die innerhalb des Halbleiterkörpers (HK) angeordnet sind.

2. Auswahlschaltung nach Anspruch 1, dadurch gekennzeichnet, daß die Eins-Aus-N-Sperr- bzw. -Kurzschlußdecoder solche für natürlich-binäcodierte Adreßsignale sind.

3. Vereinfachung der Auswahlschaltung nach Anspruch 1 oder 2, dadurch gekennzeichnet, daß nur diejenigen Teiltransistoren (P.., N..) der Transmission-Gates (G..) und die diesen Teiltransistoren zugeordneten Inverter (I..) vorhanden sind, mit denen das zugeordnete Potential (U..) schneller und niederohmiger zum Ausgang (U) durchschaltbar ist.

4. Auswahlschaltung nach Anspruch 3 für vier durchzuschaltende Potentiale (U0, U1, U2, U3), von denen das eine (U0) das des Schaltungsnullpunkts ist, gekennzeichnet durch folgende Merkmale :
— zum an den Ausgang durchgeschalteten Potential (U0) des Schaltungsnullpunkts gehören der Auswahlsignal-Zustand 00 und ein mit Source und Substrat daran angeschlossener Teiltransistor (N0) des anderen Kanalleitungstyps, dessen Gate über den zugeordneten Inverter (I0) am entsprechenden Ausgang des Eins-Aus-Vier-Binärdecoders liegt, und
— zu den anderen drei Potentialen (U1, U2, U3) gehört jeweils ein Teiltransistor (P1, P2, P3) des einen Kanalleitungstyps mit jeweils eigener Isolierwanne des anderen Kanalleitungstyps, die mit der zugehörigen Source und dem zugeordneten Potential (U1, U2, U3) verbunden ist.

5. Auswahlschaltung nach einem der Ansprüche 1 bis 4, dadurch gekennzeichnet, daß eines der Potentiale mit der Betriebsspannung (Ud) der Auswahlschaltung identisch ist.

6. Auswahlschaltung nach den Ansprüchen 4 und 5, dadurch gekennzeichnet, daß der Betriebspannung (Ud) zugeordnete Transistor (P3) in der Isolierwanne (NW) des Sperrdecoders (SD) angeordnet ist.

7. Auswahlschaltung nach einem der Ansprüche 1 bis 6, dadurch gekennzeichnet, daß die zwischen auszuwählenden Potentialen (U..) und dem Ausgang (U) liegenden Transistoren des einen Kanalleitungstyps jeweils einzelne in ihrer eigenen individuellen Isolierwanne des anderen Kanalleitungstyps angeordnet sind.

## Claims

1. Integrated selection circuit for a number (N) of potentials (U...), which is materialized in a complementary insulated-gate field-effect transistor technique (CMOS selection circuit), whereby
— to each of the N potentials (U...) there is assigned one transmission gate (G..) whose switching section lies between the potential (U...) and the output (U) of the selection circuit, and
— the two control inputs of the respective transmission gate (G...) are connected either directly or via a respectively associated inverter (I...) to the corresponding output of a CMOS-1-ex-n-decoder,
characterized by the following features :
— said CMOS-1-ex-n-decoder consists of a 1-ex-n-open-circuit decoder (SD) and of a 1-ex-n-short-circuit decoder (KD) whose address inputs are connected in pairs to one another and whose like outputs (1 ... 8) are connected to one another,
— said open-circuit decoder (SD) consists of transistors (TP) of the one channel conductivity type (p-channel in the drawings) which are arranged in one insulating island (NW) of the other channel conductivity type (n-channel in the drawings) within the semiconductor body of the integrated selection circuit, and
— said short-circuit decoder (KD) consists of transistors (TN) of the other channel conductivity type, which are arranged within the semiconductor body (HK).

2. A selection circuit as claimed in claim 1, characterized in that said-1-ex-n-open-circuit or short-circuit decoders are such ones for naturally binary encoded address signals.

3. A simplification of the selection circuit as claimed in claim 1 or 2, characterized in that only those partial transistors (P..., N...) of said transmission gates (G...) and those of the inverters (I...) associated with said partial transistors, are provided which the associated potential (U...) is capable of being connected through to the output quicker and in a more low-ohmic manner.

4. A selection circuit as claimed in claim 3, for four potentials to be connected through (U0, U1, U2, U3) of which one (U0) is that of the zero point of the circuit, characterized by the following features :
— to the potential (U0) of the zero point of the circuit as connected through to the output, there belong the selecting signal state 00 and one partial transistor (N0) of the other channel conductivity type having its source and substrate connected thereto, with the gate thereof being connected via the associated inverter (I0) to the corresponding output of the 1-ex-4-binary decoder, and
— to the other three potentials (U1, U2, U3) there each time belongs one partial transistor (P1, P2, P3) of the one channel conductivity type with respectively one insulating island of its own, of the other channel conductivity type, which is connected to the associated source and to the associated potential (U1, U2, U3).

5. A selection circuit as claimed in any one of claims 1 to 4 characterized in that one of said potentials is identical to the operating voltage (Ud) of said selection circuit.

6. A selection circuit as claimed in claims 4 and 5 characterized in that said transistor (P3) as associated with said operating voltage (Ud) is arranged in the insulating island (NW) of said open-circuit decoder (SD).

7. A selection circuit as claimed in any one of claims 1 to 6, characterized in that the transistors of the one channel conductivity type as lying between the potentials to be selected (U...) and the output (U), are each time arranged individually in their own individual insulating island of the respective other channel conductivity type.

**Revendications**

1. Circuit de sélection intégré pour un certain nombre (N) de potentiels (U...) réalisé selon la technique des transistors à effet de champ à grille isolée complémentaires (circuit de sélection CMOS), dans lequel :
— à chacun des N potentiels (U...) est affectée une porte de transmission (G...) dont la section de commutation se situe entre le potentiel (U...) et la sortie (U) du circuit de sélection, et
— les deux entrées de commande de la porte de transmission respective (G...) sont connectées, l'une directement, l'autre l'intermédiaire d'un inverseur associé (I...), à la sortie correspondante d'un décodeur CMOS du type « un sur N », caractérisé en ce que :
— ledit décodeur CMOS « un sur N » consiste en un décodeur à circuit ouvert « un sur N » (SD) et un décodeur à court-circuit « un sur N » (KD) dont les entrées d'adresses sont connectées par paires les unes aux autres et dont les sorties de même rang (1 ... 8) sont connectées l'une à l'autre,
— ledit décodeur à circuit ouvert (SD) consiste en transistors (TP) à canal d'un type de conductibilité (canal P sur les figures) qui sont disposés dans un caisson isolant (NW) de l'autre type de conductibilité de canal (canal N sur les figures) dans le corps semi-conducteur du circuit de sélection intégré, et
— ledit décodeur à court-circuit (KD) consiste en transistors (TN) à canal de l'autre type de conductibilité qui sont disposés dans le corps semi-conducteur (HK).

2. Circuit de sélection selon la revendication 1, caractérisé en ce que les décodeurs « un sur N » à circuit ouvert et à court-circuit sont du type prévu pour des signaux d'adresses à codage binaire naturel.

3. Circuit de sélection selon la revendication 1 ou 2, caractérisé en ce que seuls sont prévus ceux des transistors partiels (P..., N...) desdites portes de transmission (G...) et ceux des inverseurs (I...) qui sont associés à ces transistors partiels par lesquels le potentiel associé (U...) peut être appliqué à la sortie plus vite et avec une moindre résistance.

4. Circuit de sélection selon la revendication 3, pour la connexion de quatre potentiels (U0, U1, U2, U3) dont un est celui du potentiel de référence du circuit, caractérisé en ce que :
— au potentiel de référence du circuit (U0) devant être connecté à la sortie correspond l'état de signal de sélection 00 et un transistor partiel (N0) à canal de l'autre type de conductibilité ayant sa source et son substrat connectés à ce potentiel, sa grille étant connectée par l'intermédiaire de l'inverseur associé (I0) à la sortie correspondante du décodeur binaire « 1 sur 4 », et
— à chacun des trois autres potentiels (U1, U2, U3) sont affectés respectivement un des transistors partiels (P1, P2, P3) à canal d'un type de conductibilité, ayant un caisson d'isolement en propre, de l'autre type de conductibilité de canal, qui est connecté à la source associée et au potentiel associé (U1, U2, U3).

5. Circuit de sélection selon l'une des revendications 1 à 4, caractérisé en ce que l'un desdits potentiels est le même que la tension d'alimentation (Ud) du circuit de sélection.

6. Circuit de sélection selon les revendications 4 et 5, caractérisé en ce que ledit transistor (P3) associé à la tension d'alimentation (Ud) est disposé dans le caisson isolant (NW) du décodeur à circuit ouvert (SD).

7. Circuit de sélection selon l'une des revendications 1 à 6, caractérisé en ce que les transistors à canal d'un type de conductibilité disposés entre les potentiels à sélectionner (U...) et la sortie (U) sont disposés individuellement dans leur propre caisson isolant individuel de l'autre type de conductibilité de canal.

6

FIG. 1a

FIG. 1b

# FIG. 2

| A | L | L | L | L | L | L | L | L | H | H | H | H | H | H | H | H |
|---|---|---|---|---|---|---|---|---|---|---|---|---|---|---|---|---|
| B | L | L | L | L | H | H | H | H | L | L | L | L | H | H | H | H |
| C | L | L | H | H | L | L | H | H | L | L | H | H | L | L | H | H |
| D | L | H | L | H | L | H | L | H | L | H | L | H | L | H | L | H |
| | 0 | 1 | 2 | 3 | 4 | 5 | 6 | 7 | 8 | 9 | 10 | 11 | 12 | 13 | 14 | 15 |

# FIG. 3

# FIG. 4

FIG. 5

| A B | U |
|-----|---|
| 0 0 | U0 |
| 0 1 | U1 |
| 1 0 | U2 |
| 1 1 | U3 |

0 065 667